# EUROPÄISCHE PATENTSCHRIFT

(11) **EP 3 069 158 B1**
(45) Veröffentlichungstag und Bekanntmachung des Hinweises auf die Patenterteilung: **19.07.2017**
(21) Anmeldenummer: 14796778.0
(22) Anmeldetag: 13.11.2014
(51) Int. Cl.: H02S 50/00, G01R 31/42, G01R 31/02, H02M 7/48, H02J 3/48, H02J 3/38

(54) **VERFAHREN UND WECHSELRICHTER ZUM BESTIMMEN VON KAPAZITÄTSWERTEN VON KAPAZITÄTEN EINER ENERGIEVERSORGUNGSANLAGE**
METHOD AND INVERTER FOR DETERMINING CAPACITANCE VALUES OF CAPACITANCES OF AN ENERGY SUPPLY SYSTEM
PROCÉDÉ ET ONDULEUR SERVANT À DÉTERMINER DES VALEURS DE CAPACITÉS D'UNE INSTALLATION D'ALIMENTATION EN ÉNERGIE

(30) Priorität: 14.11.2013 DE 102013112538
(43) Veröffentlichungstag der Anmeldung: 21.09.2016
(73) Patentinhaber: SMA Solar Technology AG, 34266 Niestetal (DE)
(72) Erfinder: UNRU, Alexander, 34266 Niestetal (DE); DRANGMEISTER, Harald, 34119 Kassel (DE); MÜLLER, Tobias, 34355 Staufenberg (DE); CORREA VASQUEZ, Pablo, 97616 Bad Neustadt an der Saale (DE)
(86) Internationale Anmeldenummer: PCT/EP2014/074528
(87) Internationale Veröffentlichungsnummer: WO 2015/071378

(56) Entgegenhaltungen:
- EP-A2- 1 107 439
- WO-A1-2012/119232
- JP-A- 2002 335 632
- JP-A- 2008 043 061
- US-A1- 2005 169 018
- US-A1- 2010 091 532

## Beschreibung

Die Erfindung betrifft ein Verfahren zum Bestimmen von Kapazitätswerten von Kapazitäten einer Energieversorgungsanlage, beispielsweise einer Photovoltaik-Anlage, die einen mehrphasigen Wechselrichter aufweist, der wechselstromseitig einen Ausgangsstromfilter aufweist und über ein Schaltorgan mit einem mehrphasigen Energieversorgungsnetz verbunden ist, und dem gleichstromseitig mindestens eine Zwischenkreiskapazität zugeordnet ist. Die Erfindung betrifft weiterhin einen mehrphasigen Wechselrichter mit einer Steuereinrichtung zur Durchführung eines solchen Verfahrens.

Wechselrichter werden in Energieerzeugungsanlagen, beispielsweise Photovoltaik-Anlagen, abkürzend im folgenden PV-Anlagen genannt, zur Umwandlung eines Gleichstroms in Wechselstrom eingesetzt, der ein- oder mehrphasig in ein öffentliches oder privates Energieversorgungsnetz eingespeist werden kann. Im Falle einer Photovoltaik-Anlage wird der umzuwandelnde Gleichstrom von einem Photovoltaikgenerator (PV-Generator) bereitgestellt, der im Rahmen der Anmeldung jede Anordnung von bevorzugt mehreren Photovoltaikmodulen (PV-Modulen) umfasst. Alternativ und/oder zusätzlich kann (ggf. zwischengespeicherter) Gleichstrom aus Batterien oder Brennstoffzellen oder vergleichbaren chemisch arbeitenden Stromquellen bereitgestellt werden.

Derartige Energieversorgungsanlagen weisen in einem Gleichstromzwischenkreis eine Anordnung von (Puffer)-Kondensatoren auf, um die von dem Gleichstromgenerator bereitgestellte Gleichspannung beim Umwandeln in Wechselstrom zu glätten. Bei einem einstufigen Wechselrichter, bei dem eine Wechselrichterbrücke eingangsseitig unmittelbar mit der Spannung des Gleichstromgenerators beaufschlagt ist, ist eine derartige Kondensatoranordnung parallel zum Gleichstromgenerator geschaltet. Bei einem mehrstufigen Wechselrichter ist der Wechselrichterbrücke mindestens ein Gleichspannungswandler vorgeschaltet, der die von dem Gleichstromgenerator bereitgestellte Gleichspannung auf ein für den Betrieb der Wechselrichterbrücke geeignetes Spannungsniveau hoch- oder tiefsetzstellt. Bei einem derartigen System ist die Kondensatoranordnung üblicherweise zwischen dem Gleichspannungswandler, auch DC (direct current) /DC-Wandler genannt, und der Wechselrichterbrücke angeordnet. Im Rahmen der Anmeldung wird im Folgenden unabhängig von der Position der Kondensatoranordnung verallgemeinert der Kreis, in dem die Kondensatoranordnung angeordnet ist, der üblichen Terminologie folgend als Zwischenkreis bezeichnet. Entsprechend wird die zur Glättung der Spannung eingesetzte Kondensatoranordnung in beiden Fällen als Zwischenkreis-Kondensatoranordnung bezeichnet.

Die Wechselrichterbrücke eines Wechselrichters ist üblicherweise mit Leistungshalbleiterschaltern bestückt, die in einem Modulationsverfahren getaktet betrieben werden. Ein bekanntes und übliches Modulationsverfahren ist das Pulsweiten-Modulationsverfahren (PWM-Verfahren), das mit einer Taktfrequenz, also einer Anzahl von Schaltzyklen pro Sekunde, im Kilohertz-Bereich betrieben wird. Am Ausgang der Wechselrichterbrücke wird dadurch ein getaktetes und seine Polarität wechselndes Gleichstromsignal bereitgestellt, das von einem Ausgangsstromfilter so geglättet wird, dass sich ein möglichst sinusförmiger Spannungsverlauf am Ausgang des Filters ergibt. Der Ausgangsstromfilter wird aus diesem Grund häufig auch als Sinusfilter bezeichnet.

Der Ausgangsstromfilter umfasst dabei eine Mehrzahl von Induktivitäten und Kapazitäten. Ein bekannter und häufig eingesetzter Ausgangsstromfilter weist für jede der Phasen des Wechselrichters mindestens eine Induktivität auf, z. B. einer Spule, die zwischen dem jeweiligen Ausgang der Wechselrichterbrücke und dem entsprechenden Phasenanschluss des Energieversorgungsnetzes angeordnet ist. Weiterhin ist am wechselrichterseitigen Eingang des Filters jeweils eine Kapazität zwischen jedem Ausgangsanschluss der Wechselrichterbrücke und einem Nullleiter des Systems angeordnet. Ausgangsseitig, also zum Energieversorgungsnetz hin, ist für jede Phase eine zweite Kapazität vorgesehen. Diese zweite Kapazität ist in Sternschaltung geschaltet, kontaktiert also einen gemeinsamen, schwebenden Spannungsknoten. Die erste und zweite Kapazität wird üblicherweise durch entsprechende erste und zweite Kondensatoren gebildet.

Die korrekte und sichere Funktion des Wechselrichters der Energieerzeugungsanlage ist im hohen Maße von den genannten Kapazitäten, der Zwischenkreiskapazität und den Kapazitäten im Ausgangsstromfilter, abhängig. Die für die Bereitstellung der Kapazitäten verwendeten Kondensatoren unterliegen jedoch Alterungsprozessen, durch die ihr Kapazitätswert im Laufe der Zeit absinkt. Bei Elektrolytkondensatoren wird zusätzlich eine starke Temperaturabhängigkeit bei Temperaturen unterhalb des Gefrierpunkts beobachtet. Bei Kenntnis der geänderten Kapazitätswerte kann bis zu einem gewissen Kapazitätsverlust die korrekte Funktionsweise des Wechselrichters durch Anpassen von Parametern des Wechselrichters, beispielsweise Regelparametern, die die Schaltzeiten im Schaltzyklus der Leistungshalbleiter der Wechselrichterbrücke bestimmen, ausgeglichen werden. Bei zu großen Abweichungen der Kapazitäten ist es sinnvoll, den Betrieb des Wechselrichters zu beenden, um weiterreichende Zerstörungen des Wechselrichters oder der Kondensatoren zu vermeiden. Sowohl zur Anpassung der Betriebsparameter des Wechselrichters, als auch zur Abschaltung des Wechselrichters oder zur Ausgabe einer im Vorfeld auf möglicherweise zu erwartende Probleme hinweisenden Warnung ist eine Kenntnis der Kapazitätswerte von Kapazitäten der Energieerzeugungsanlage, insbesondere der Zwischenkreiskapazitäten und der Filterkapazitäten, wünschenswert.

Aus der Druckschrift DE 10 2004 036 211 A1 ist dazu beispielsweise ein Verfahren bekannt, bei dem ein Zwischenkreiskondensator bei Inbetriebnahme der Vorrichtung über einen Ladewiderstand vorgeladen wird. Aus einer Messung des Ladestroms und eines gemessenen Spannungsverlaufs am Zwischenkreiskondensator kann während der Vorladung die Kapazität des Zwischenkreiskondensators ermittelt werden. Dieses Verfahren bietet sich insbesondere dann an, wenn eine Vorladung des oder der Zwischenkreiskondensatoren vorgesehen ist und die Vorrichtung über eine entsprechende Vorladevorrichtung verfügt.

Auf ähnliche Weise wird gemäß der Druckschrift WO 02/18962 A1 der Zwischenkreiskondensator eines Wechselrichters einer Motorsteuerung durch einen Entladewiderstand bei Inaktivität der Motorsteuerung entladen. Aus einem gemessenen Spannungsverlauf beim Entladen wird die Kapazität des Zwischenkreiskondensators bestimmt.

Aus der Druckschrift US 2012/0281443 A1 ist ein Verfahren zum Ermitteln eines defekten Kondensators eines aus einer Reihenschaltung von mehreren Kondensatoren bestehenden Zwischenkreises bekannt. Es werden dabei die über den einzelnen Kondensatoren abfallenden Spannungen gemessen und aus der Höhe der Spannungen wird auf einen defekten Kondensator geschlossen. Die Druckschrift US 2013/0155729 A1 beschreibt ein Verfahren zur Vorhersage einer zu erwartenden Lebenszeit eines Zwischenkreiskondensators eines Motorumrichters. Bei diesem Verfahren wird ein in dem Kondensator fließender Wechselstromanteil ermittelt und daraus eine im Betrieb im Kondensator deponierte Leistung bestimmt. Aus der deponierten Leistung wird auf den Alterungszustand und damit die noch zu erwartende Lebenszeit des Kondensators geschlossen. Mit den in beiden genannten Druckschriften beschriebenen Verfahren können jedoch keine Kapazitätswerte der Kondensatoren ermittelt werden.

Die Druckschrift EP1107439A2 offenbart einen Wechselrichter mit einer Wechselrichterbrückenschaltung, einem Ausgangsstromfilter, einer gleichstromseitigen Zwischenkreiskapazität und ausgangsseitig der Wechselrichterbrückenschaltung angeordneten Spannungs- und Stromsensoren. Der Wechselrichter gemäß der EP1107439A2 weist zudem eine Steuereinrichtung auf, die zur Detektion eines Erdschlussfehlers eingerichtet ist.

Aus der JP2008043061A ist ein Verfahren zur Bestimmung von Kapazitätswerten von Zwischenkreiskapazitäten eines Wechselrichters durch Messen eines zeitlichen Verlaufes einer Entladung der Zwischenkreiskapazitäten bekannt. Die Druckschrift WO2012119232A1 offenbart ein Verfahren zur Bestimmung von Kapazitätswerten von Zwischenkreiskapazitäten eines Wechselrichters durch Auswertung von Spannungsrippeln an der Zwischenkreiskapazität.

Die Druckschrift US 2009/0072982 A1 beschreibt eine Anlage zur Energieumwandlung, bei der die zeitliche Variation der Spannungen an Kondensatoren der Anlage gemessen wird und die Höhe eines Spannungsrippels an den Kondensatoren bestimmt wird. Zudem werden die beim Auftreten des Spannungsrippeis fließenden Ströme bestimmt. Aus der Höhe des Spannungsrippels und der Höhe des fließenden Stroms wird die Kapazität des Kondensators ermittelt. Ein vergleichbares Verfahren beschreibt auch die Druckschrift EP 2 690 452 A2. Diese Verfahren können vorteilhaft sein, wenn eine Ermittlung der Kapazitäten während des Normalbetriebs der Energieversorgungsanlage gewünscht ist. Aus Sicherheitsgründen ist es jedoch häufig gewünscht, eine entsprechende Diagnose der korrekten Funktionsfähigkeit der Kondensatoren vorzunehmen, bevor sich eine Energieerzeugungsanlage mit dem Energieversorgungsnetz verbindet. Beispielsweise kann es problematisch sein, eine Energieversorgungsanlage mit hoher Leistung zu betreiben, wenn die Kapazität von Zwischenkreiskondensatoren temperaturbedingt auf extrem kleine Werte abgefallen ist. Dieses Problem tritt beispielsweise im Zusammenhang mit Elektrolytkondensatoren als Zwischenkreiskondensatoren bei Freiland-PV-Anlagen unter extremen Witterungsbedingungen auf. In der Regel erfolgt ein Anfahren einer solchen PV-Anlage erst nach einem Anwärmen der Zwischenkreiskondensatoren durch eine dafür vorgesehene Heizvorrichtung.

Es ist daher eine Aufgabe der vorliegenden Erfindung, ein Verfahren zum Bestimmen von Kapazitäten in einer Energieerzeugungsanlage zu schaffen, das möglichst ohne zusätzlichen apparativen Aufwand durchgeführt werden kann, bevor die Energieerzeugungsanlage mit einem Energieversorgungsnetz gekoppelt wird und sich im Einspeisebetrieb befindet. Es ist eine weitere Aufgabe, einen Wechselrichter zu schaffen, der zur Durchführung eines solchen Verfahrens geeignet ist.

Diese Aufgabe wird gelöst durch ein Verfahren und einen Wechselrichter mit den Merkmalen des jeweiligen unabhängigen Anspruchs. Vorteilhafte Ausgestaltungen und Weiterbildungen sind in den abhängigen Ansprüchen angegeben.

Ein erfindungsgemäßes Verfahren der eingangs genannten Art weist die folgenden Schritte auf: Die Photovoltaik-Anlage wird durch Öffnen des Schaltorgans von dem Energieversorgungsnetz getrennt. Der Wechselrichter wird zum Aufbau eines Inselnetzes betrieben, wobei mindestens zwei Ausgänge einer Wechselrichterbrücke des Wechselrichters mit einer gleichphasigen Wechselspannung beaufschlagt werden und ein Stromfluss zwischen der mindestens einen Zwischenkreiskapazität und dem Ausgangsstromfilter erzeugt wird. An den Ausgängen der Wechselrichterbrücke fließende Ströme und mindestens eine der an der Zwischenkreiskapazität und/oder an einer der Kapazitäten des Ausgangsstromfilters anliegenden Spannungen werden gemessen. Anschließend wird anhand der ermittelten jeweiligen Spannung und der gemessenen Ströme ein Kapazitätswert der Zwischenkreiskapazität und/oder einer der Kapazitäten des Ausgangsstromfilters bestimmt.

Durch den Aufbau eines Inselnetzes, bei dem der Ausgangsstromfilter durch die Wechselrichterbrücke mit einer Wechselspannung beaufschlagt wird, wird auch bei Trennung von dem Energieversorgungsnetz ein Stromfluss zwischen der mindestens einen Zwischenkreiskapazität und dem Ausgangsstromfilter generiert. Mittels einer Strom- und Spannungsmessung können dann Kapazitätswerte von Kapazitäten der PV-Anlage ermittelt werden. Dadurch, dass mindestens zwei Phasen gleichphasig betrieben werden, stellt sich ein größerer Stromfluss und aufgrund der entstehenden pulsierenden Leistungsentnahme aus der Zwischenkreiskapazität eine größerer Rippel der ermittelten Spannung ein, als es in einem normalen Betrieb, bei dem alle Phasen zueinander phasenverschoben sind, der Fall wäre. So wird eine höhere Messgenauigkeit erzielt.

Bei einer vorteilhaften Ausgestaltung des Verfahrens wird die Spannung über mindestens einer der Zwischenkreiskapazitäten der PV-Anlage gemessen. Aus der Höhe eines Rippels der Spannung und den gemessenen Strömen wird der Kapazitätswert der mindestens einen Zwischenkreiskapazität bestimmt. Mit dem erfindungsgemäßen Verfahren wird in dieser Ausgestaltung die Bestimmung der Kapazitätswerte des Zwischenkreiskondensators bzw. der Zwischenkreiskondensatoren vor einem Aufschalten des Wechselrichters auf das Energieversorgungsnetz, also vor einer Verbindung des Wechselrichters mit dem Energieversorgungsnetz, möglich.

Bei zeitlich variierendem Stromfluss in/aus dem Zwischenkreis variiert die Höhe der Spannung an der mindestens einen Zwischenkreiskapazität mit einer Frequenz, die mit der Frequenz des Stroms zusammenhängt und - abhängig von der Phasenbeziehung an den Ausgängen der Wechselrichterbrücke - bei der zwei- oder dreifachen Frequenz des Stroms im Inselnetz liegt. Die Variation der Spannung an der mindestens einen Zwischenkreiskapazität wird im Rahmen der Anmeldung auch als Spannungsrippel bezeichnet.

Bei einer weiteren vorteilhaften Ausgestaltung des Verfahrens wird die Spannung über mindestens einer ersten Kapazität des Ausgangsstromfilters ermittelt, wobei aus der ermittelten Spannung und den gemessenen Strömen der Kapazitätswert der mindestens einen ersten Kapazität bestimmt wird. Damit ist auch die Bestimmung von Kapazitätswerten von Kondensatoren des Ausgangsstromfilters vor dem Aufschalten des Wechselrichters auf das Energieversorgungsnetz möglich. In dieser Ausgestaltung ist das Verfahren insbesondere geeignet, um Kapazitätswerte von Kondensatoren zu bestimmen, die zwischen einem Ausgang der Wechselrichterbrücke und einem gemeinsamen Nullleiter angeordnet sind.

Besonders hohe Ströme werden bei den genannten Verfahren erzielt, wenn alle Ausgänge der Wechselrichterbrücke des Wechselrichters gleichphasig mit Wechselspannung beaufschlagt werden. Dieses führt zu einer bestmöglichen Genauigkeit bei der Kapazitätswertbestimmung.

Bei einer weiteren vorteilhaften Ausgestaltung des Verfahrens wird die Spannung über mindestens einer zweiten Kapazität des Ausgangsstromfilters ermittelt, wobei der Kapazitätswert der mindestens einen zweiten Kapazität anhand von mindestens zwei Messungen von Spannungen und Strömen bestimmt wird, wobei die mindestens zwei Messungen bei unterschiedlichen Phasenbeziehungen der Wechselspannungen an den Ausgängen der Wechselrichterbrücke erfolgt. In dieser Ausgestaltung ist das Verfahren geeignet, Kapazitätswerte auch von Kondensatoren zu bestimmen, die innerhalb des Ausgangsstromfilters zwischen verschiedenen Ausgängen der Wechselrichterbrücke angeordnet sind. Hier werden zwei Messungen bei unterschiedlichen Phasenbeziehungen an den Ausgängen der Wechselrichterbrücke durchgeführt, durch die die durch die zweiten Kapazitäten fließenden Ströme rechnerisch von solchen Strömen getrennt werden können, die über Kapazitäten zu einem gemeinsamen Nullleiter fließen.

Bei einem dreiphasigen Wechselrichter werden dabei bevorzugt in jeder der mindestens zwei Messungen jeweils zwei Ausgänge der Wechselrichterbrücke mit einer gleichphasigen Wechselspannung und ein dritter Ausgang der Wechselrichterbrücke mit einer davon in ihrer Phasenlage abweichenden Wechselspannung beaufschlagt. Besonders bevorzugt weist die am dritten Ausgang anliegende Wechselspannung eine Phasenlage von 180 Grad zu der an den anderen beiden Ausgängen der Wechselrichterbrücke anliegenden Wechselspannung auf. So wird wiederum ein maximaler Stromfluss erzielt, der die Genauigkeit bei der Bestimmung der Kapazitätswerte erhöht. Weiter bevorzugt werden drei Messungen durchgeführt, wobei in jeder der Messungen ein anderer der Ausgänge der Wechselrichterbrücke mit der in ihrer Phasenlage abweichenden Wechselspannung beaufschlagt wird. Auf diese Weise können die jeweiligen Kapazitätswerte auf Basis verschiedener Messungen bestimmt werden. Die Messergebnisse weisen eine gewisse Redundanz auf, durch die einzelnen Kapazitätswerte überbestimmt sind. Die Überbestimmtheit ermöglicht eine Abschätzung der Qualität und damit Aussagekraft des Messergebnisses. Bei einer weiteren vorteilhaften Ausgestaltung des Verfahrens wird ein ermittelter Kapazitätswert mit einem vorgegebenen Mindestkapazitätswert verglichen, wobei ein unterhalb des Mindestkapazitätswertes liegender Kapazitätswert signalisiert wird. Weiter vorteilhaft wird ein ermittelter Kapazitätswert abgespeichert und mit zuvor abgespeicherten Kapazitätswerten verglichen. Bevorzugt wird aus dem ermittelten Kapazitätswert und mindestens einem abgespeicherten Kapazitätswert eine Änderungsrate des Kapazitätswertes bestimmt, wobei anhand der Änderungsrate eine Lebensdauer des die Kapazität bereitstellenden Kondensators abgeschätzt wird. Bei diesen Ausgestaltungen des Verfahrens wird die Kapazitätsbestimmung vorteilhaft verwendet, um einen Anlagenbetreiber vor aktuellen oder möglicherweise bevorstehenden Problemen zu warnen. Gegenmaßnahmen können so unverzüglich oder vorsorglich eingeleitet werden.

Bei einer weiteren vorteilhaften Ausgestaltung wird das Verfahren während eines Startvorgangs des Wechselrichters mehrfach durchgeführt. So kann ein möglicherweise nur temporäres Problem, das sich während der (oder auch durch die) Ausführung des Verfahrens löst, identifiziert werden und der Aufstartvorgang ggf. fortgesetzt werden. Dabei kann vorgesehen sein, bei einer Änderung der ermittelten Zwischenkreiskapazität während des Verfahrens dieses zur Erwärmung von Kondensatoren im Zwischenkreis durchzuführen. Der im Verfahren hervorgerufene Stromfluss kann so zur Erwärmung der Kondensatoren eingesetzt werden, wodurch eine temperaturbedingte Kapazitätserniedrigung aufgrund des relativ kleinen fließenden Stroms schonend behoben werden kann.

Bei einer weiteren vorteilhaften Ausgestaltung wird das Verfahren bei verschiedenen Frequenzen der Wechselspannung an den Ausgängen der Wechselrichterbrücke durchgeführt. Mit den dann frequenzabhängig vorliegenden Messwerten kann ein Induktivitätswert mindestens einer Induktivität des Ausgangsstromfilters bestimmt werden. Damit sind die Größen aller Komponenten eines typischen Ausgangsstromfilters bestimmbar.

Ein erfindungsgemäßer mehrphasiger Wechselrichter zur Verbindung mit einem Energieversorgungsnetz weist eine Steuereinrichtung mit einer Auswerteeinheit auf. Er zeichnet sich dadurch aus, dass die Steuereinrichtung in Verbindung mit der Auswerteeinheit zur Durchführung eines der zuvor beschriebenen Verfahren eingerichtet ist. Es ergeben sich die im Zusammenhang mit den Verfahren beschriebenen Vorteile.

Die Erfindung wird nachfolgend anhand von Ausführungsbeispielen mithilfe von Figuren näher erläutert. Die Figuren zeigen:
- Fig. 1: ein schematisches Blockschaltbild einer PV-Anlage;
- Fig. 2a: eine detaillierte Darstellung eines Teils der PV-Anlage der Fig. 1;
- Fig. 2b: eine auf eine Phase beschränkte vereinfachte Darstellung der Fig. 2a;
- Fig. 3: ein Flussdiagramm eines erfindungsgemäßen Verfahrens;
- Fig. 4: ein Diagramm zur Darstellung einer typischen Abnahme einer Kapazität während der Lebenszeit eines Kondensators;
- Fig. 5a: ein Flussdiagramm mit Verfahrensschritten zum Bestimmen von Zwischenkreiskapazitäten;
- Fig. 5b, c: jeweils ein Flussdiagramm mit Verfahrensschritten zum Bestimmen von ersten bzw. zweiten Kapazitäten eines Ausgangsstromfilters;
- Fig. 6a - d: jeweils ein schematisches Ersatzschaltbild von einem Teil der PV-Anlage während der Durchführung der Verfahren gemäß Fig. 4 und
- Fig. 7a, b: jeweils ein Diagramm einer zeitabhängigen Kapazitätsänderung eines Zwischenkreiskondensators während eines kontinuierlich durchgeführten Verfahrens gemäß Fig. 4a.

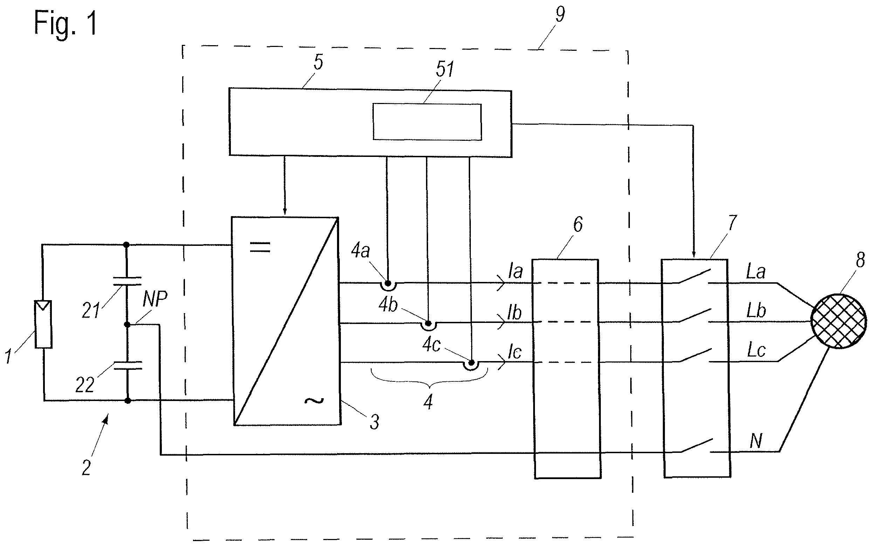

Fig. 1 zeigt in einem Blockschaltbild eine Übersicht über den Gesamtaufbau einer PV-Anlage. Die PV-Anlage umfasst einen PV-Generator 1, der in Fig. 1 durch das Schaltbild einer einzelnen PV-Zelle symbolisiert ist. Der PV-Generator 1 kann in bekannter Weise ein oder mehrere PV-Module umfassen. Beim Einsatz mehrerer PV-Module sind diese häufig zu sogenannten Strings reihenverschaltet. Mehrerer dieser Strings können parallel geschaltet sein, um den PV-Generator 1 zu bilden.

Der PV-Generator 1 ist über Gleichstromleitungen mit einem Zwischenkreis 2 verbunden, der im hier dargestellten Ausführungsbeispiel zwei in Reihe geschaltete Zwischenkreiskapazitäten 21, 22 umfasst. Der Mittelabgriff zwischen den beiden Zwischenkreiskapazitäten 21, 22 bildet einen virtuellen Nullpunkt NP, der ein Bezugspotential für die Gleichstromseite der PV-Anlage bereitstellt.

Der PV-Generator 1 ist über den Zwischenkreis 2 mit einem gleichstromseitigen Eingang einer Wechselrichterbrücke 3 verbunden. Die Wechselrichterbrücke 3 dient der Umwandlung des von dem PV-Generator 1 erzeugten Gleichstroms in einen an Ausgängen der Wechselrichterbrücke 3 ausgegebenen Wechselstrom. Die Wechselstromausgänge der Wechselrichterbrücke 3 sind mit einem Ausgangsstromfilter 6 verbunden, wobei in der Verbindung zwischen der Wechselrichterbrücke 3 und dem Ausgangsstromfilter 6 Strommesssensoren 4 angeordnet sind.

Die Wechselrichterbrücke 3 ist mehrphasig, hier beispielhaft dreiphasig ausgebildet. Zur Unterscheidung der drei unterschiedlichen Phasen werden nachfolgend die Zusätze "a", "b" und "c" in Verbindung mit Bezugszeichen oder Bezeichnungen verwendet. Komponenten, die den einzelnen Phasen a, b, c zugeordnet sind, sind in ihren Bezugszeichen durch ein hinzugefügtes "a" bzw. "b" oder "c" gekennzeichnet. Wird ein Bezugszeichen ohne einen solchen Zusatz verwendet, so sind entweder alle Komponenten mit diesem Bezugszeichen unabhängig von ihrem Zusatz adressiert oder eine nicht näher spezifizierte dieser Komponenten mit diesem Bezugszeichen. Ein Verweis auf den "Strommesssensor 4" bezieht sich also je nach Zusammenhang entweder auf die Strommesssensoren 4a, 4b und 4c gemeinsam oder aber auf einen nicht näher spezifizierten der Strommesssensoren 4a, 4b oder 4c.

Die Strommesssensoren 4 dienen der Bestimmung von am jeweiligen Ausgang der Wechselrichterbrücke 3 fließenden Strömen Ia, Ib und Ic. Die Ausgänge der Strommesssensoren 4 werden einer Steuereinrichtung 5 zugeführt, die eine Auswerteeinheit 51 zur Messung und Auswertung der Ausgänge der Strommesssensoren 4 umfasst. Die Steuereinrichtung 5 übernimmt weiterhin der Ansteuerung der Wechselrichterbrücke 3, hier insbesondere der in dieser Figur nicht näher dargestellten Halbleiterschalter der Wechselrichterbrücke 3.

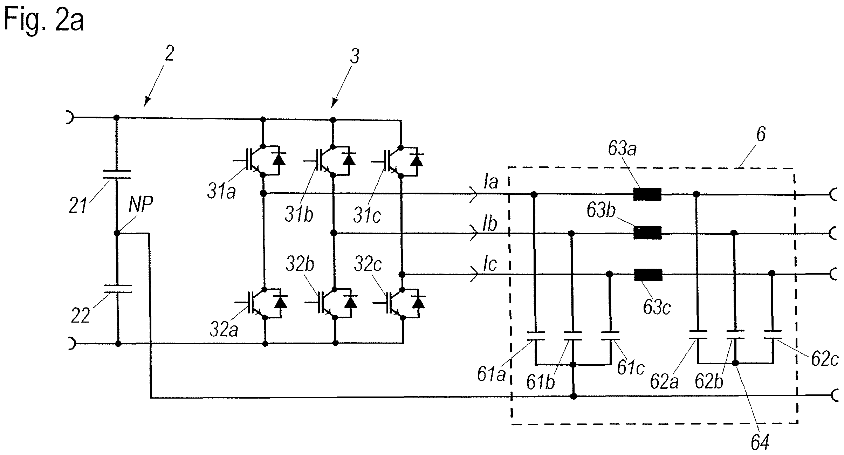

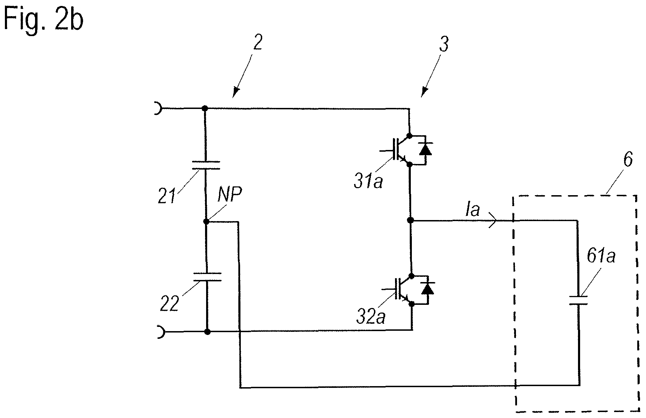

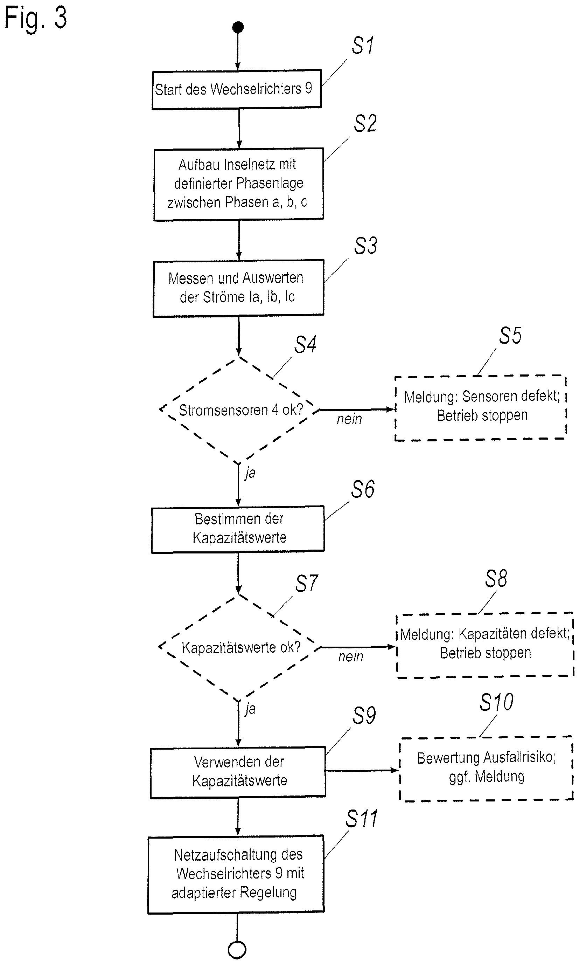

Der Ausgangsstromfilter 6 dient der Signalformung des Ausgangssignals der Wechselrichterbrücke 3. Ohne Ausgangsstromfilter ist das Ausgangssignal der Wechselrichterbrücke 3 im Wesentlichen ein zwischen verschiedenen Potentialen wechselndes pulsierendes Gleichspannungssignal. Der Ausgangsstromfilter 6 formt aus diesem gepulsten Gleichspannungssignal einen in etwa wechselspannungsförmigen Ausgangsstrom, der über ein Wechselspannungs- (AC - alternating current) Schaltorgan 7 in ein Energieversorgungsnetz 8 eingespeist werden kann. Wie die Wechselrichterbrücke 3 ist auch das Energieversorgungsnetz 8 dreiphasig ausgebildet, mit Phasenleitern La, Lb und Lc. Weiterhin ist ein Nullleiter N vorhanden, der ebenfalls über das AC-Schaltorgan 7 und den Ausgangsstromfilter 6 mit dem virtuellen Nullpunkt NP der Gleichstromseite der PV-Anlage 1 verbunden ist. Der Ausgangsstromfilter 6 umfasst üblicherweise eine Anordnung aus mehreren Kapazitäten und Induktivitäten. Eine typische Ausgestaltung eines Ausgangsstromfilters 6 ist nachfolgend im Zusammenhang mit den Figuren 2 und 3 näher beschrieben.

Im dargestellten Ausführungsbeispiel sind die Wechselrichterbrücke 3, die Strommesssensoren 4, die Steuereinrichtung 5 und der Ausgangsstromfilter 6 in einem Wechselrichter 9 integriert. In alternativen Ausgestaltungen kann beispielsweise zusätzlich der Zwischenkreis 2 mit in dem Wechselrichter 9 integriert sein, oder aber der Ausgangsstromfilter 6 in einem separaten Gehäuse angeordnet sein.

Es wird angemerkt, dass in der Fig. 1 lediglich im Rahmen der Anmeldung wesentliche Elemente der PV-Anlage dargestellt sind. So können auf der Gleich- und/oder Wechselstromseite beispielsweise nicht dargestellte weitere Schaltorgane (z.B. Trennelemente, Schütze), Schutzeinrichtungen (z.B. Sicherungen), Überwachungseinrichtungen und/oder Transformatoren vorgesehen sein.

Fig. 2a zeigt einen Ausschnitt aus Fig. 1 detaillierter. Nicht dargestellt ist in der Fig. 2a der PV-Generator 1, die Steuereinrichtung 5, das AC-Schaltorgan 7 und das Energieversorgungsnetz 8.

In Fig. 2a ist der Aufbau der Wechselrichterbrücke 3 für die drei Phasen a, b, c angedeutet. Die Wechselrichterbrücke 3 weist für jede der drei Phasen einen Brückenzweig auf, der in dem hier dargestellten Beispiel zwei Halbleiterschalter 31, 32 umfasst. Als Halbleiterschalter sind beispielhaft IGBT (insulated-gate bipolar transistor) -Schalter dargestellt. Es versteht sich, dass die Wechselrichterbrücke 3 ebenso mit anderen Halbleiterleistungsschaltern, beispielsweise MOSFETs (metal oxide semiconductor field-effect transistors) aufgebaut sein kann. Den Halbleiterschaltern 31, 32 sind nicht näher benannte Freilaufdioden zugeordnet, die externe Bauelemente sein können oder in die Halbleiterschalter 31, 32 integriert sein können. Den Halbleiterschaltern 31, 32 vorgeschaltete Bauelemente, die ihrer Ansteuerung dienen, sind aus Gründen der Übersichtlichkeit in der Fig. 2a nicht dargestellt. Die Schaltsignale für die Halbleiterschalter 31, 32 werden letztlich von der Steuereinrichtung 5 gemäß bekannten Modulationsverfahren, insbesondere Pulsweitenmodulationsverfahren (PWM), generiert und über die entsprechenden Ansteuerschaltungen auf die Halbleiterschalter 31, 32 übertragen.

In der Fig. 2a ist eine Zweipunkt-Topologie der Wechselrichterbrücke 3 dargestellt, bei der jeder Wechselstromausgang der Wechselrichterbrücke 3, der von dem Mittelabgriff zwischen dem in Reihe geschalteten Halbleiterschaltern 31, 32 gebildet ist, wahlweise mit einem positiven Pol des PV-Generators 1 bzw. einem negativen Pol des PV-Generators 1 verbunden werden kann. Es versteht sich, dass andere Topologien eingesetzt werden können, insbesondere eine Dreipunkttopologie, bei der zusätzlich die Möglichkeit besteht, den Ausgangsanschluss der Wechselrichterbrücke 3 über einen bidirektional arbeitenden weiteren Halbleiterschalter mit dem Bezugspotential am virtuellen Nullpunkt NP, also dem Mittelabgriff zwischen den Zwischenkreiskapazitäten 21, 22, zu verbinden.

Der Ausgangsstromfilter 6 weist für jede der Phasen a, b, c zwei Kapazitäten 61, 62 sowie eine Induktivität 63 auf. Die Kapazitäten 61, 62 werden üblicherweise von Kondensatoren, typischerweise Folienkondensatoren, gebildet. Die erste Kapazität 61 ist dabei bei jeder der Phasen a, b, c zwischen dem Ausgangsanschluss der Wechselrichterbrücke 3, der den Eingang des Ausgangsstromfilters 6 darstellt, und dem Nullleiter N angeordnet. Die Induktivität 63 ist jeweils zwischen Eingangs- und Ausgangsanschlüssen des Ausgangsstromfilters 6 angeordnet. Die Ausgangsanschlüsse des Ausgangsstromfilters 6 sind jeweils mit einer zweiten Kapazität 62 verbunden, wobei die jeweils anderen Anschlüsse der zweiten Kapazitäten 62 an einen gemeinsamen virtuellen Sternpunkt 64 führen. Der Ausgang des Ausgangsstromfilters 6 ist dann in der in der Fig. 1 gezeigten Weise über das AC-Schaltorgan 7 mit dem Energieversorgungsnetz 8 verbunden.

In der Fig. 2b ist der Übersichtlichkeit halber für die weiteren Betrachtungen die Fig. 2a auf eine der Phasen, hier beispielhaft die Phase a, beschränkt wiedergegeben. Der Ausgangsstromfilter 6 ist in einem Ersatzschaltbild dargestellt, das für einen Betriebszustand gilt, in dem die drei Phasen a, b, c gleichphasig betrieben werden. Aufgrund der Gleichphasigkeit aller Phasen a, b, c fließen keine Ströme durch die Kapazitäten 62. Da der Wechselrichter 9 vom Energieversorgungsnetz 8 durch das geöffnete AC-Schaltorgan 7 getrennt ist, also eine Inselnetzsituation vorliegt, fließen auch durch die Induktivitäten 63 keine Ströme. In einem Ersatzschaltbild des Ausgangstromfilters 6 können diese Komponenten also für den genannten Betriebszustand des Wechselrichters 9 ignoriert werden.

Anhand der nachfolgend beschriebenen Figuren 3 bis 5 werden erfindungsgemäße Verfahren zum Bestimmen von Kapazitätswerten der Kapazitäten der PV-Anlage erläutert. Die Verfahren können beispielsweise in der in Fig. 1 und 2 dargestellten PV-Anlage und insbesondere mithilfe des dort verwendeten Wechselrichters ausgeführt werden. Sie werden daher beispielhaft mit Bezug auf diese Figuren und unter Verwendung der dort benutzten Bezugszeichen erläutert.

Fig. 3 zeigt einen grundsätzlichen Ablauf eines anmeldungsgemäßen Verfahrens in einem Flussdiagramm.

In einem ersten Schritt S1 startet der Wechselrichter 9 der PV-Anlage, beispielsweise nach einer Zeitperiode, in der vom PV-Generator 1 keine ausreichende Leistung zum Betrieb des Wechselrichters und zur Einspeisung in das Energieversorgungsnetz 8 geliefert wurde, also z.B. nach einer Nacht. Bei dem Startvorgang des Wechselrichters 9 ist der Ausgang der Wechselrichterbrücke 3 durch ein geöffnetes AC-Schaltorgan 7 vom Energieversorgungsnetz 8 getrennt. Ein Start des Wechselrichters 9 erfolgt, sobald eine dafür ausreichende Leistung von dem PV-Generator 1 bereitgestellt wird.

In einem zweiten Schritt S2 wird bei geöffnetem Schaltorgan 7 vom Wechselrichter ein sogenanntes Inselnetz aufgebaut. In einem Einspeisebetrieb des Wechselrichters herrscht bei einem dreiphasigen Netz zwischen den einzelnen Phasen a, b, c jeweils eine Phasenverschiebung von 120 Grad. Die Phasenlage des Gesamtsystems ist angepasst an die im Energieversorgungsnetz herrschende. In dem Schritt S2 wird bei dem Inselnetz eine davon abweichende Phasenbeziehung der Phasen a, b, c untereinander aufgebaut, indem mindestens zwei der Phasen gleichphasig zueinander sind (Phasenverschiebung 0 Grad). Bevorzugt werden alle drei Phasen gleichphasig mit einer Phasenverschiebung von 0 Grad zueinander betrieben. Im Folgenden wird von einer solchen Situation, in der alle drei Phasen a, b, c gleichphasig betrieben werden, ausgegangen.

In einem nächsten Schritt S3 werden die beim Betreiben des Inselnetzes am Ausgang der Wechselrichterbrücke 3 fließenden Ströme Ia, Ib und Ic durch die Strommesssensoren 4a, 4b bzw. 4c gemessen und in der Auswerteeinheit 51 ausgewertet.

In einem für das Verfahren zum Bestimmen der Kapazitätswerte der Kapazitäten der PV-Anlage zunächst optionalen Schritt wird in einem Schritt S4 anhand der Strommesswerte aus Schritt S3 eine Plausibilitätsprüfung vorgenommen, um defekte Stromsensoren 4 zu identifizieren. Beispielsweise würden stark voneinander abweichende Strommesswerte Ia, Ib, Ic eher auf einen defekten Stromsensor schließen lassen, als auf Unterschiede in den zu ermittelnden Kapazitäten. Auch ein Stromwert, der konstant null beträgt, deutet auf einen defekten Stromsensor hin. Bei der Ermittlung, ob ein Stromwert Ia, Ib, Ic auf einen defekten Stromsensor schließen lässt, können auch Stromwerte vergleichbarer Messungen aus der Vergangenheit, die zu Protokollzwecken gespeichert wurden, herangezogen werden.

Wenn in dem Schritt S4 ein Stromsensor als defekt erkannt wird, verzweigt das Verfahren zu einem Schritt S5, indem das Vorhandensein eines defekten Stromsensors 4 signalisiert wird, beispielsweise durch Versenden einer entsprechenden Meldung an eine übergeordnete Überwachungseinrichtung über eine Signal- und/oder Datenleitung. Das Verfahren wird daraufhin beendet und der Betrieb des Wechselrichters eingestellt.

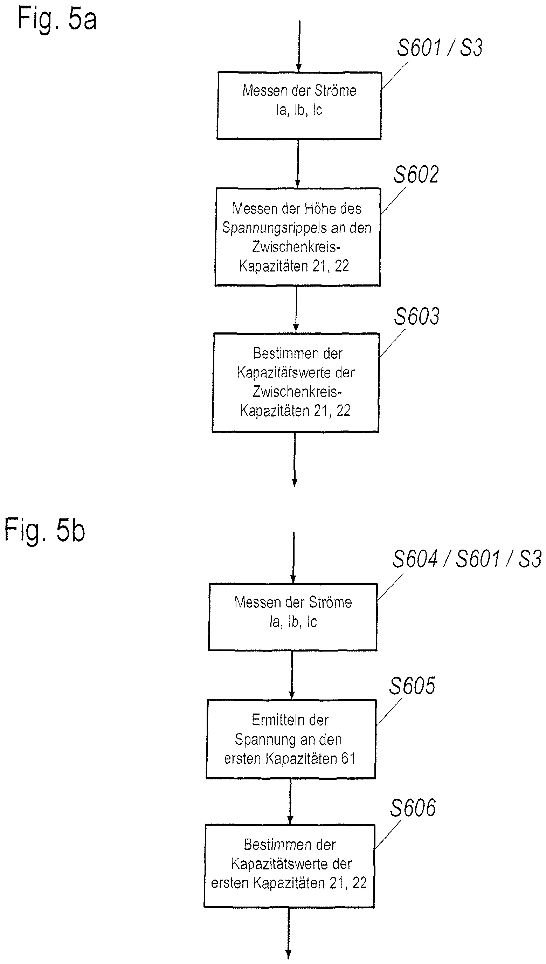

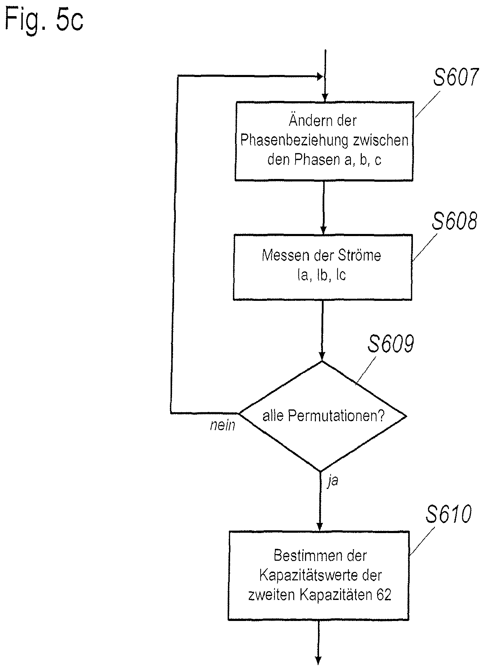

Wenn in dem Schritt S4 die Stromwerte Ia, Ib, Ic zumindest in einem plausibel erscheinenden Bereich liegen, wird das Verfahren mit einem Schritt S6 fortgeführt, in dem die eigentliche Bestimmung der Kapazitätswerte erfolgt. Plausibilitätsgrenzen für die entsprechenden Stromwerte lassen sich im Falle eines Ausgangsstromfilters, der Induktivitäten und Kapazitäten (LC-Filter) aufweist, und unter Berücksichtigung von Bauteil- und sonstigen Toleranzen auf Basis der Impedanz des Ausgangsstromfilters, der gemessenen Ströme und der gemessenen oder vorgegebenen Spannungen am Ausgangsstromfilter ermitteln. Details zu dem Schritt S6 werden in den Figuren 5a, 5b und 5c in weiteren Flussdiagrammen näher erläutert.

Das Ergebnis der Kapazitätsbestimmung aus dem Schritt S6 wird in einem nachfolgenden Schritt S7 bewertet. Dabei wird anhand von hinterlegten Grenzwerten betrachtet, ob die Kapazitäten in einem vorgegebenen Toleranzbereich liegen oder nicht. Dabei können zum einen absolute Werte der Kapazitäten betrachtet werden, insbesondere Grenzwerte relativ zu Nennwerten der Kapazitäten, und zum anderen auch Änderungsraten der Kapazitäten. Ähnlich wie zuvor im Zusammenhang mit der Überprüfung der Stromsensoren im Schritt S4 beschrieben, werden auch die ermittelten Kapazitäten vorzugsweise in einem Protokollspeicher protokolliert, so dass in vorhergehenden Messungen bestimmte Kapazitätswerte ebenfalls zur Beurteilung der aktuell gemessenen Kapazitätswerte herangezogen werden können. Bevorzugt wird das hier beschriebene Verfahren zum Bestimmen der Kapazitätswerte innerhalb einer PV-Anlage regelmäßig, beispielsweise bei jedem Startvorgang am Morgen - und damit zumindest einmal täglich - durchgeführt, so dass eine kontinuierliche Beobachtung der Kapazitätswerte möglich ist.

Liegen die Kapazitätswerte nicht in einem geeigneten Toleranzbereich, verzweigt das Verfahren zu einem Schritt S8, in dem die entsprechende Kapazität bzw. der Kapazität zugrundeliegende Kondensator als defekt signalisiert wird, beispielsweise wiederum durch eine entsprechende Meldung über die Signal- und/oder Datenleitung zu der übergeordneten Überwachungseinrichtung. Wie im Schritt S5 wird daraufhin der Betrieb des Wechselrichters 9 beendet.

Wenn in dem Schritt S7 die Kapazitäten als innerhalb des Toleranzbereichs liegend erkannt wurden, wird das Verfahren mit einem Schritt S9 fortgesetzt, in dem die ermittelten Kapazitätswerte weiterverarbeitet werden. Zum einen erfolgt in diesem Schritt S9 die Protokollierung der Kapazitätswerte, entweder innerhalb der Steuereinrichtung 5 oder innerhalb der übergeordneten Überwachungseinrichtung. Zum anderen können die ermittelten Kapazitätswerte verwendet werden, um Steuerungs- und/oder Regelungsparameter für den Wechselrichter 9 zu optimieren und damit die Einspeiseströme optimal einzustellen und Instabilitäten in der Regelung zu verhindern.

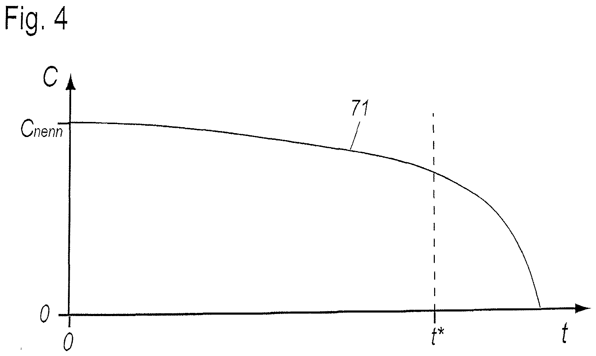

Aus der kontinuierlichen Beobachtung der Kapazitätswerte kann eine aktuelle Änderungsrate der Kapazitätswerte ermittelt werden, beispielsweise die tägliche prozentuale oder absolute Änderung der Kapazitätswerte. Eine starke Änderung der Kapazitätswerte deutet auf einen bevorstehenden Ausfall des entsprechenden Kondensators hin. In Fig. 4 ist eine typische Zeitverlaufskurve 71 einer Kapazität C eines Kondensators wiedergegeben. Dargestellt ist die Abnahme der Kapazität C von einer nominellen Nennkapazität Cnenn mit fortschreitender Zeit t. Typischerweise verlieren Kondensatoren ihre Kapazität zunächst sehr langsam mit geringen Änderungsraten über einen langen Zeitraum, bevor sich ab einem bestimmten Zeitpunkt, der hier beispielhaft bei t=t* als gestrichelte Linie eingezeichnet ist, die Änderungsrate schnell vergrößert und die Kapazität rasch abfällt.

Wenn anhand der Änderungsraten der Kapazitätswerte ein Ausfall eines der Kondensatoren bevorsteht, kann in einem ebenfalls optionalen Schritt S10 eine entsprechende Servicemeldung zur vorsorglichen Wartung bzw. zum Austausch des entsprechenden Kondensators ausgegeben werden.

Schließlich kann in einem Schritt S11 der Startvorgang des Wechselrichters 9 fortgesetzt werden und sich der Wechselrichter 9 mit den im Schritt S9 optimierten Parametern für den Einspeisebetrieb auf das Energieversorgungsnetz 8 aufschalten.

Fig. 5 zeigt in drei Flussdiagrammen in den Teilbildern a bis c Details der Bestimmung der Kapazitätswerte während des Verfahrensschritts S6 aus Fig. 3. Im Flussdiagramm der Fig. 5a werden Verfahrensschritte zum Bestimmen der Kapazität der Zwischenkreiskondensatoren 21, 22 beschrieben. Das Flussdiagramm der Fig. 5b beschreibt Verfahrensschritte zum Bestimmen der Kapazitätswerte der ersten Kapazitäten 61 des Ausgangsstromfilters 6. Das in Fig. 5c dargestellte Verfahren gibt die Verfahrensschritte zum Bestimmen der Kapazitätswerte der zweiten Kapazitäten 62 des Ausgangsstromfilters 6 wieder.

Die in Fig. 5a und 5b dargestellten Verfahren können unabhängig voneinander durchgeführt werden. Das in Fig. 5c gezeigte Verfahren setzt die vorherige Durchführung des Verfahrens aus Fig. 5b voraus. In einer bevorzugten Ausgestaltung des Verfahrens nach Fig. 3 werden im Schritt S6 die in allen Teilfiguren 5a bis 5c gezeigten Verfahrensschritte nacheinander durchgeführt, um vorteilhaft Informationen über alle relevanten Kapazitäten der PV-Anlage, also die Zwischenkreiskapazitäten 21, 31, die ersten Kapazitäten 61 und die zweiten Kapazitäten 62 des Ausgangsstromfilters 6, zu erhalten.

In einem ersten Schritt S601 der Fig. 5a wird die Strommessung aus Schritt S3 entweder erneut durchgeführt oder es werden die in Schritt S3 gemessenen Stromwerte zur weiteren Auswertung übernommen. Die Strommessung im Schritt S601 wird also ebenso wie die Strommessung S3 in einem Betriebszustand des Wechselrichters durchgeführt, in dem alle drei Phasen a, b, c gleichphasig ohne Phasenverschiebung zueinander im Inselnetzbetrieb durch die Wechselrichterbrücke 3 mit Spannung beaufschlagt werden. Aufgrund der Gleichphasigkeit aller Phasen a, b, c fließen bei geöffnetem AC-Schaltorgan 7 weder durch die Induktivitäten 63 noch durch die Kapazitäten 62 Ströme. Wie in dem Ersatzschaltbild des Ausgangstromfilters 6 in Fig. 2b gezeigt ist, können diese Komponenten entsprechend für diesen Betriebszustand des Wechselrichters 9 ignoriert werden. Elektrisch ist in diesem Betriebszustand nur die Kapazität 61 relevant und zu berücksichtigen.

Die drei ersten Kapazitäten 61 a, 61 b, 61 c der drei Phasen sind somit gewissermaßen parallel geschaltet und werden mit der Ausgangsstromfrequenz der Ströme Ia, Ib, Ic, üblicherweise also mit 50 Hz oder mit 60 Hz, umgeladen. Ladung wird somit durch das Schalten der Halbleiterschalter 31, 32 permanent zwischen den ersten Kapazitäten 61 und den Zwischenkreiskapazitäten 21, 22 hin und her transferiert, wobei die Größe des die Ladung übertragenden Stroms in dem Schritt S601 bzw. S3 gemessen wurde. Der Ladungstransfer führt zu einer permanenten Auf- und Entladung der Zwischenkreiskapazitäten 21, 22, was sich in einer Variation der an diesen Kapazitäten 21, 22 anliegenden Spannungen zeigt. Die Variation der Spannung an den Zwischenkreiskapazitäten 21, 22 wird auch als Spannungsrippel bezeichnet. Der Spannungsrippel wäre auch bei einem nicht phasengleichen Betreiben der Phasen a, b, c zu beobachten, z.B. wenn alle drei Phasen um jeweils 120° phasenverschoben zueinander betrieben würden, wäre in seiner Intensität dann jedoch deutlich kleiner und damit schlechter zu messen. Dieses gilt insbesondere, da die Spannung im Zwischenkreis einige 100 Volt betragen kann, wohingegen der Spannungsrippel bei den in dieser Inselnetzsituation vorkommenden Umladeströmen im Bereich von höchstens einigen Volt oder auch weniger als einem Volt liegt. Das gleichphasige Betreiben der Phasen a, b, c führt zu dem für diese Umladeströme größtmöglichen zu beobachtenden Spannungsrippel und ist damit vorteilhaft für die Messgenauigkeit.

Aus der Höhe des gemessenen Spannungsrippels in Verbindung mit den gemessenen Strömen Ia, Ib, Ic kann der Kapazitätswert der Zwischenkreiskapazitäten 21, 22, der im Wesentlichen auf die verwendeten Zwischenkreiskondensatoren zurückzuführen ist, ermittelt werden.

Dabei kann der folgende Zusammenhang zwischen den Kapazitätswerten C₂₁ bzw. C₂₂ der Zwischenkreiskapazitäten 21 bzw. 22 und einer gemessenen Amplitude Û₂₁ bzw. Û₂₂ des jeweiligen Spannungsrippels an der Zwischenkreiskapazitäten 21 bzw. 22, und der Amplitude Î der Summe der gemessenen Ströme Ia, Ib und Ic zugrunde gelegt werden: C₂₁ = Î / (ω Û₂₁) und entsprechend C₂₂ = Î / (ω Û₂₂), wobei ω die Kreisfrequenz des Wechselstroms Ia, Ib, Ic angibt. Für einen Zwischenkreis mit nur einer Zwischenkreiskapazität ist entsprechend nur eine der Beziehungen zu berücksichtigen.

Das in Fig. 5b dargestellte Verfahren zum Bestimmen der Kapazitätswerte der ersten Kapazitäten 61 des Ausgangsstromfilters 6 kann im Anschluss an das in Fig. 5a gezeigte Verfahren durchgeführt werden. Es ist aber auch möglich, das in Fig. 5b dargestellte Verfahren durchzuführen, ohne dass das in Fig. 5a dargestellte Verfahren zuvor ausgeführt wurde.

In einem ersten Schritt S604 werden wiederum die an den gleichphasigen Ausgängen der Wechselrichterbrücke fließenden Ströme Ia, Ib, Ic gemessen. Wenn das in Fig. 5a gezeigte Verfahren zuvor ausgeführt wurde, können die Messwerte aus dem Schritt S601 übernommen werden. Weiterhin ist es auch hier möglich, die Messwerte aus dem Schritt S3 zu verwenden.

In einem nächsten Schritt S605 wird die Höhe der Spannung, auf die die ersten Kapazitäten 61 aufgeladen werden, ermittelt. Diese Spannung kann entweder gemessen werden oder kann aus Vorgaben entnommen werden, da der Wechselrichter im Inselbetrieb üblicherweise die Höhe der Ausgangswechselspannung am Ausgang der Wechselrichterbrücke 3 auf diesen vorgegebenen Spannungswert ausregelt, indem die Halbleiterschalter 31, 32 die an den Zwischenkreiskapazitäten 21, 22 anliegende Spannung geeignet moduliert. In einem dann folgenden Schritt S606 werden die Kapazitätswerte der ersten Kapazitäten 61 anhand der entsprechenden Wertepaare aus Strom Ia, Ib, Ic und der an den Kapazitäten 61, 62 anliegenden Spannung ermittelt.

In dem Flussdiagramm der Fig. 3 ist die Überprüfung der Kapazitäten im Schritt S7 der Bestimmung der Kapazitätswerte im Schritt S6 nachgelagert. Es versteht sich, dass eine Abfrage, ob ein ermittelter Kapazitätswert im Toleranzbereich liegt, bereits nach jedem der Teilverfahren der Fig. 5a bzw. 5b erfolgen kann.

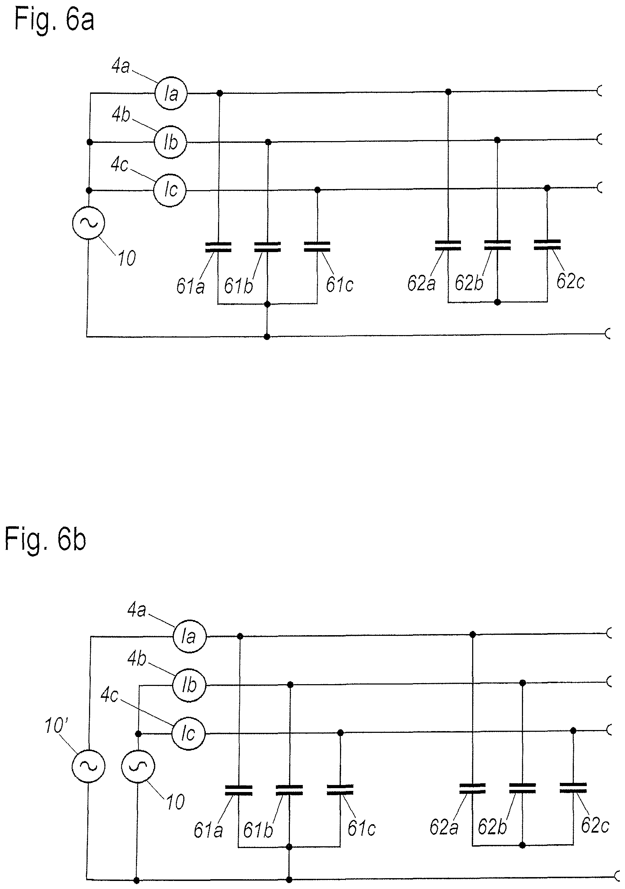

In Fig. 6a ist die den Verfahren der Fig. 5a und 5b zugrundeliegende Betriebssituation des Wechselrichters der PV-Anlage nochmals in anderer Art dargestellt. Bei dieser schematischen Zeichnung ist der Wechselrichter durch das Ersatzschaltbild einer Spannungsquelle 10 wiedergegeben. Die Gleichphasigkeit der Phasen a, b, c äußert sich in dem Vorliegen nur einer Spannungsquelle 10, an der alle Phasen parallel angeschlossen sind.

Nach Bestimmung der Kapazitätswerte der ersten Kapazitäten 61 des Ausgangsstromfilters 6 wird zum Bestimmen der zweiten Kapazitäten 62 des Ausgangsstromfilters 6 das in Fig. 5c dargestellte Verfahren ausgeführt.

In einem ersten Schritt S607 dieses Verfahrens wird die Ansteuerung der Halbleiter 31, 32 der Wechselrichterbrücke 30 so modifiziert, dass sich eine geänderte Phasenbeziehung zwischen den Phasen a, b, c ergibt. Nach wie vor wird dabei ein Inselnetz beibehalten. Konkret wird bei erster Ausführung des Schrittes S607 die Gleichphasigkeit für zwei der Phasen a, b, c beibehalten, wohingegen die dritte der Phasen demgegenüber mit einer Phasenverschiebung von 180 Grad bezüglich der Spannung betrieben wird.

Diese Situation ist im Ersatzschaltbild der Fig. 6b analog zum Ersatzschaltbild der Fig. 6a dargestellt. Beispielhaft werden hier die Phasen b und c gleichphasig betrieben, indem sie an die Spannungsquelle 10 angeschlossen sind. Eine dazu mit umgekehrter Polarität betriebene Spannungsquelle 10' beaufschlagt dagegen die Phase a mit einer Phasenverschiebung in der Spannung von 180 Grad. Nachdem sich dieser Betriebszustand eingestellt hat, wird in einem darauffolgenden Schritt S608 wiederum eine Strommessung der Ströme Ia, Ib, Ic vorgenommen.

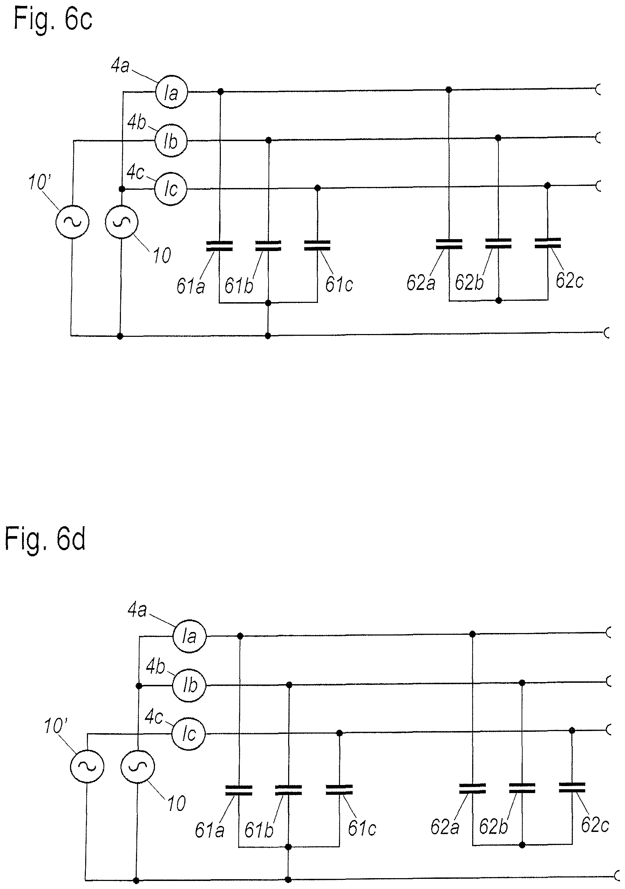

In einem Schritt S609 verzweigt das Verfahren zurück zum Schritt S607, in dem nun die Phasenbeziehung der Phasen a, b, c zueinander derart geändert wird, das nun eine andere der Phasen gegensinnig zu zwei gleichsinnigen Phasen betrieben wird. Diese Situation ist in dem Ersatzschaltbild der Fig. 6c wiedergegeben, in der die Phasen a und c gemeinsam, d.h. phasengleich, von der ersten Spannungsquelle 10 betrieben werden und die Phase b mit einer Phasenverschiebung von 180 Grad von der Spannungsquelle 10'. Wiederum wird der Schritt S608 durchlaufen, in dem die Ströme Ia, Ib, Ic gemessen und abgespeichert werden. Bei einem erneuten Durchlauf des Schrittes S609 wird abgefragt, ob nunmehr alle möglichen Permutationen der Phasenbeziehungen durchgespielt sind. Ist dieses nicht der Fall, verzweigt das Verfahren wiederum zurück in den Schritt S607, um die nunmehr letzte der Permutationen einzustellen, die in Fig. 6d im Ersatzschaltbild wiedergegeben ist. Bei dieser Kombination werden die Phasen a und b gleichphasig an der Spannungsquelle 10 betrieben und die Phase c gegensinnig dazu an der Spannungsquelle 10'. Wiederum werden im Schritt S608 die Ströme Ia, Ib, Ic gemessen und danach das Verfahren im Schritt S610 weitergeführt.

Aufgrund der Phasenverschiebung jeweils einer der Phasen gegenüber den anderen beiden Phasen gilt für die in den Fig. 6b bis 6d dargestellten Betriebssituationen nicht mehr die bei den Fig. 5a und 5b gemachte Annahme, dass durch die zweiten Kapazitäten 62 keine Ströme fließen. Vielmehr stellt sich hier ein Verschiebestrom durch Umladung zwischen den ersten Kapazitäten 61 und den zweiten Kapazitäten 62 in verschiedenen Kombinationen ein. Die sich einstellenden Ströme können mit den Kapazitätswerten in Beziehung gesetzt werden. Es ergibt sich ein Gleichungssystem, das nach Kapazitätswerten der Kapazitäten 62 aufgelöst werden kann, wenn sowohl die ersten Kapazitäten 61 als auch die Ströme Ia, Ib, Ic in den einzelnen Betriebssituationen bekannt sind. Die Lösung des Gleichungssystems im Schritt S610 führt dann zum Bestimmen der zweiten Kapazitäten 62.

Werden in dem dargestellten Verfahren in den Schritten S607 und 608 alle drei möglichen Permutationen eingestellt und gemessen, ist das Gleichungssystem für die drei zweiten Kapazitäten 62 überbestimmt. Die Überbestimmtheit ermöglicht eine Abschätzung der Qualität und damit Aussagekraft des Messergebnisses. Im Prinzip würde in den Schritten S607 und S608 das Vermessen von zwei Permutationen ausreichen, um die Kapazitätswerte der drei Kapazitäten 62 bestimmen zu können.

Bei der Auswertung im Schritt S610 bleiben die Induktivitäten 63 unberücksichtigt, da sie beim Ausführen der Messungen bei der Netzfrequenz üblicherweise so dimensioniert sind, dass sie keinen oder nur einen vernachlässigbaren Einfluss auf die Messwerte haben. Grundsätzlich ist es jedoch möglich, die im Schritt S6 der Fig. 3 durchgeführten Messungen zusätzlich bei einer höheren Frequenz durchzuführen, bei der der Einfluss der Induktivitäten 63 nicht mehr zu vernachlässigen ist. Ein Vergleich der Ergebnisse der Messungen bei höherer Frequenz mit denen der Messungen bei Netzfrequenz ermöglicht dann zusätzlich die Bestimmung der Größen der Induktivitäten 63. Weiter wird angemerkt, dass im Ausgangsstromfilter 6 weitere Induktivitäten vorgesehen sein können, beispielsweise zwischen dem Ausgang der Wechselrichterbrücke und dem Anschluss der ersten Induktivitäten 61. Auch diese Induktivitäten sind zunächst unbeachtlich, könnten jedoch bestimmt werden, falls das in Fig. 5b dargestellte Verfahren zum Bestimmen der Kapazitätswerte der ersten Kapazitäten 61 bei verschiedenen Frequenzen durchgeführt wird.

In einer alternativen Ausgestaltung des Verfahrens kann vorgesehen sein, die Messungen des Schrittes S6 gemäß Fig. 3 wiederholt durchzuführen, insbesondere wenn die bestimmten Kapazitätswerte außerhalb eines erwarteten Bereichs liegen. Vorteilhaft ist dieses für die Bestimmung der Kapazitätswerte der Zwischenkreiskapazitäten 21, 22 gemäß Fig. 5a. Zur Bereitstellung der Zwischenkreiskapazitäten 21, 22 werden häufig Elektrolytkondensatoren eingesetzt, da diese relativ kostengünstig sind und bezogen auf ihr Volumen und ihr Gewicht eine große Kapazität bereitstellen. Bei sehr niedrigen Temperaturen unterhalb des Gefrierpunktes können Elektrolytkondensatoren aufgrund einer Aggregatzustandsänderung des Elektrolyts ("Einfrieren" des Elektrolyts) drastisch an Kapazität verlieren. Ein Betreiben der PV-Anlage in einem derartigen Zustand ist nicht nur kaum möglich, da die Regelcharakteristik des Wechselrichters nicht auf derart kleine Kapazitätswerte eingestellt ist, sondern zudem gefährlich, da die starke Impulsstrombelastung im eingefrorenen Zustand die Elektrolytkondensatoren zerstören könnte.

Die während des Messverfahrens der Fig. 5a erfolgende ständige Ladungsverschiebung zwischen den Zwischenkreiskapazitäten 21, 22 und den Kapazitäten 61 des Ausgangsstromfilters 6 deponiert jedoch Verlustleistung in Form von Wärme in den Zwischenkreiskondensatoren 21, 22. Wird diese Betriebszustand des Wechselrichters 9 über längere Zeit aufrechterhalten, können sich die Zwischenkreiskondensatoren 21, 22 dadurch langsam und kontrolliert aufwärmen und erreichen so wieder ihren ursprünglichen Kapazitätswert. Wird das in Fig. 5a gezeigte Verfahren daher mehrfach und insbesondere quasi kontinuierlich durchgeführt, kann eine Veränderung der gemessenen Kapazität der Kapazitäten 21, 22 im Schritt S603 beobachtet werden.

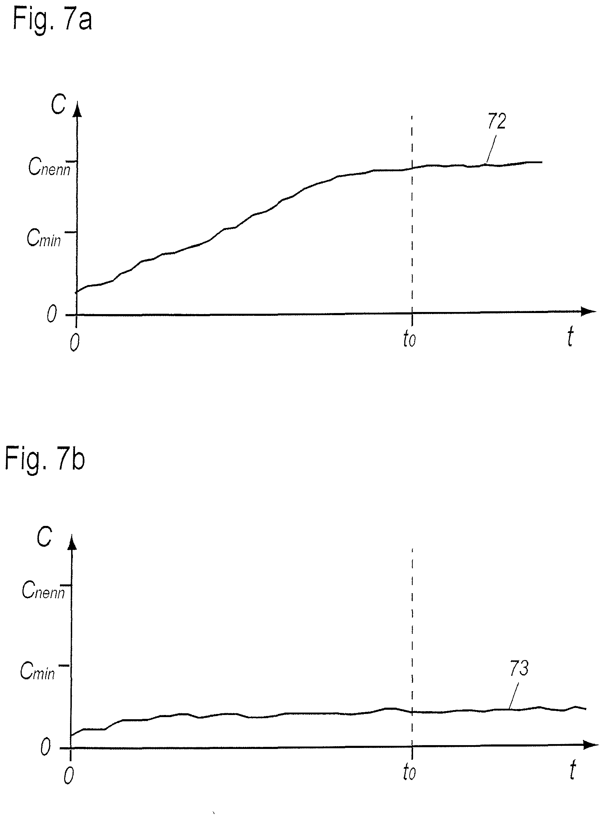

Dieses ist in Fig. 7 in zwei Teilbildern a, b für zwei verschiedene Situationen dargestellt. In den Diagrammen ist je eine Zeitverlaufskurve 72 bzw. 73 eines Kapazitätswertes C bei fortschreitender Zeit t dargestellt. Auf der vertikalen Achse ist der gemessene Kapazitätswert C einer der Zwischenkreiskapazitäten 21, 22 dargestellt und auf der horizontalen Achse die Zeit t.

Zum Zeitpunkt t = 0, bei dem eine erste Messung gemäß Fig. 5a durchgeführt wurde, liegt die Kapazität C des Zwischenkreiskondensators 21, 22 deutlich unterhalb einer für das Betreiben der PV-Anlage notwendigen Mindestkapazität Cmin. Die gemessene Kapazität C steigt mit wachsender Zeit t kontinuierlich an, übersteigt den notwendigen Mindestwert Cmin und nähert sich asymptotisch dem nominellen Kapazitätswert Cnenn. Wird bei einer kontinuierlichen Ausführung der Kapazitätsbestimmung gemäß Fig. 5a ein derartiges Verhalten beobachtet, kann auf eine "eingefrorene" Zwischenkreiskapazität 21, 22 geschlossen werden, wobei während des Messverfahrens die Temperatur der entsprechenden Kondensatoren im Zwischenkreis 2 soweit angehoben wird, dass anschließend ein Einspeisebetrieb der PV-Anlage erfolgen kann.

Bei dem in Fig. 7b dargestellten Beispiel wird bei einem ersten Durchlauf des Messverfahrens zum Zeitpunkt t=0 eine vergleichbar kleine Kapazität C für die Zwischenkreiskapazitäten 21 bzw. 22 gemessen. Auch nach längerer Laufzeit des Messverfahrens ändert sich diese Kapazität C nicht wesentlich und verbleibt unterhalb der für den Betrieb der PV-Anlage notwendigen minimalen Kapazität Cmin. Nach Ablauf einer vorgegebenen Zeitdauer, die eine maximale Messzeit festlegt, kann im Fall b darauf geschlossen werden, dass die beobachtete geringe Kapazität für die Zwischenkreiskapazitäten 21, 22 auf einen Defekt eines oder mehrerer der verwendeten Kondensatoren zurückzuführen ist und nicht auf ein Einfrieren. Entsprechend würde gemäß Schritt S8 aus Fig. 3 eine Defektmeldung ausgegeben werden und der Startvorgang des Wechselrichters 9 abgebrochen.

### Bezugszeichenliste

- 1: PV-Generator
- 2: Zwischenkreis
- 3: Wechselrichterbrücke
- 4: Strommesssensoren
- 5: Steuereinrichtung
- 6: Ausgangsstromfilter
- 7: AC-Schaltorgan
- 8: Energieversorgungsnetz
- 9: Wechselrichter
- 10, 10': Spannungsquelle
- 21, 22: Zwischenkreiskapazität
- 31, 32: Halbleiterschalter
- 51: Auswerteeinheit
- 61: erste Kapazität
- 62: zweite Kapazität
- 63: Induktivität
- 64: Sternpunkt
- 71, 72, 73: Kapazitätsverlaufskurve
- Ia, Ib, Ic: Strom
- La, Lb, Lc: Phasenleiter
- N: Nullleiter
- NP: Nullpunkt (Bezugspotential)
- C: Kapazitätswert
- Cnenn: Nennkapazität
- Cmin: Mindestkapazität
- S1-S11: Verfahrensschritt
- S601-S603: Verfahrensschritt
- S604-S606: Verfahrensschritt
- S607-S610: Verfahrensschritt

## Patentansprüche

1. Verfahren zum Bestimmen von Kapazitätswerten von Kapazitäten (21, 22, 61, 62) einer Photovoltaik-Anlage, aufweisend einen mehrphasigen Wechselrichter (9), der wechselstromseitig einen Ausgangsstromfilter (6) aufweist und über ein Schaltorgan (7) mit einem mehrphasigen Energieversorgungsnetz (8) verbunden ist, und dem gleichstromseitig mindestens eine Zwischenkreiskapazität (21, 22) zugeordnet ist, mit den folgenden Schritten:
- Trennen der Photovoltaik-Anlage von dem Energieversorgungsnetz (8) durch Öffnen des Schaltorgans (7);
- Betreiben des Wechselrichters (9) zum Aufbau eines Inselnetzes, wobei mindestens zwei Ausgänge einer Wechselrichterbrücke (3) des Wechselrichters (9) mit einer gleichphasigen Wechselspannung beaufschlagt werden und ein Stromfluss zwischen der mindestens einen Zwischenkreiskapazität (21, 22) und dem Ausgangsstromfilter (6) erzeugt wird;
- Messen von an den Ausgängen der Wechselrichterbrücke (3) fließenden Strömen (Ia, Ib, Ic) und mindestens einer der an der Zwischenkreiskapazität (21, 22) und/oder an einer Kapazität (61, 62) des Ausgangsstromfilters (6) anliegenden Spannungen und
- Bestimmen eines Kapazitätswertes der Zwischenkreiskapazität (21, 22) und/oder einer der Kapazitäten (61, 62) des Ausgangsstromfilters (6) anhand der ermittelten jeweiligen Spannung und der gemessenen Ströme (Ia, Ib, Ic).

2. Verfahren nach Anspruch 1, bei dem die Spannung über mindestens einer der Zwischenkreiskapazitäten (21, 22) der Photovoltaik-Anlage gemessen wird, wobei aus der Höhe eines Rippels der Spannung und den gemessenen Strömen (Ia, Ib, Ic) der Kapazitätswert der mindestens einen Zwischenkreiskapazität (21, 22) bestimmt wird.

3. Verfahren nach Anspruch 1, bei dem die Spannung über mindestens einer ersten Kapazität (61) des Ausgangsstromfilters (6) ermittelt wird, wobei aus der ermittelten Spannung und den gemessenen Strömen (Ia, Ib, Ic) der Kapazitätswert der mindestens einen ersten Kapazität (61) bestimmt wird.

4. Verfahren nach einem der Ansprüche 1 bis 3, bei dem alle Ausgänge der Wechselrichterbrücke (3) des Wechselrichters (9) gleichphasig mit Wechselspannung beaufschlagt werden.

5. Verfahren nach Anspruch 1, bei dem die Spannung über mindestens einer zweiten Kapazität (62) des Ausgangsstromfilters (6) ermittelt wird, wobei der Kapazitätswert der mindestens einen zweiten Kapazität (62) anhand von mindestens zwei Messungen von Spannungen und Strömen (Ia, Ib, Ic) bestimmt wird, wobei die mindestens zwei Messungen bei unterschiedlichen Phasenbeziehungen der Wechselspannungen an den Ausgängen der Wechselrichterbrücke (3) erfolgt.

6. Verfahren nach Anspruch 5, durchgeführt bei einem dreiphasigen Wechselrichter (9), wobei in jeder der mindestens zwei Messungen jeweils zwei Ausgänge der Wechselrichterbrücke (3) mit einer gleichphasigen Wechselspannung und ein dritter Ausgang der Wechselrichterbrücke (3) mit einer davon in ihrer Phasenlage abweichenden Wechselspannung beaufschlagt werden.

7. Verfahren nach Anspruch 6, bei dem die am dritten Ausgang anliegende Wechselspannung eine Phasenlage von 180 Grad zu der an den anderen beiden Ausgängen der Wechselrichterbrücke (3) anliegenden Wechselspannung aufweist.

8. Verfahren nach Anspruch 5 oder 6, bei dem drei Messungen durchgeführt werden, wobei in jeder der Messungen ein anderer der Ausgänge der Wechselrichterbrücke (3) mit der in ihrer Phasenlage abweichenden Wechselspannung beaufschlagt wird.

9. Verfahren nach einem der Ansprüche 1 bis 8, bei dem ein ermittelter Kapazitätswert (C) mit einem vorgegebenen Mindestkapazitätswert (Cmin) verglichen wird, wobei ein unterhalb des Mindestkapazitätswertes (Cmin) liegender Kapazitätswert (C) signalisiert wird.

10. Verfahren nach einem der Ansprüche 1 bis 9, bei dem ein ermittelter Kapazitätswert (C) abgespeichert wird und mit zuvor abgespeicherten Kapazitätswerten verglichen wird.

11. Verfahren nach Anspruch 10, bei dem aus dem ermittelten Kapazitätswert (C) und mindesten einem abgespeicherten Kapazitätswert eine Änderungsrate des Kapazitätswertes bestimmt wird, wobei anhand der Änderungsrate eine Lebensdauer des die Kapazität bereitstellenden Kondensators abgeschätzt wird.

12. Verfahren nach einem der Ansprüche 1 bis 11, das während eines Startvorgangs des Wechselrichters (9) mehrfach durchgeführt wird.

13. Verfahren nach Anspruch 12, wobei bei einer Änderung der ermittelten Zwischenkreiskapazität (21, 22) das Verfahren zur Erwärmung von Kondensatoren im Zwischenkreis (2) durchgeführt wird.

14. Verfahren nach einem der Ansprüche 1 bis 13, das bei verschiedenen Frequenzen der Wechselspannung an den Ausgängen der Wechselrichterbrücke (3) durchgeführt wird, um ein Induktivitätswert mindestens einer Induktivität (63) des Ausgangsstromfilters (6) zu bestimmen.

15. Mehrphasiger Wechselrichter (9) zur Verbindung mit einem Energieversorgungsnetz (8), aufweisend eine Steuereinrichtung (5) mit einer Auswerteeinheit (51), **dadurch gekennzeichnet, dass** die Steuereinrichtung (5) in Verbindung mit der Auswerteeinheit (51) zur Durchführung eines Verfahrens gemäß einem der vorstehenden Ansprüche eingerichtet ist.

## Claims

1. A method for determining capacitance values of capacitances (21, 22, 61, 62) of a photovoltaic system comprising a multiphase inverter (9) which comprises an output current filter (6) on the alternating current side and is connected to a multiphase energy supply network (8) via a switching element (7) and is associated with at least one intermediate circuit capacitance (21, 22) on the direct current side, having the following steps of:
- disconnecting the photovoltaic system from the energy supply network (8) by opening the switching element (7);
- operating the inverter (9) to set up an island network, an in-phase AC voltage being applied to at least two outputs of an inverter bridge (3) of the inverter (9) and a flow of current being produced between the at least one intermediate circuit capacitance (21, 22) and the output current filter (6);
- measuring currents (Ia, Ib, Ic) flowing at the outputs of the inverter bridge (3) and at least one voltage present at the intermediate circuit capacitance (21, 22) and/or a capacitance (61, 62) of the output current filter (6),and
- determining a capacitance value of the intermediate circuit capacitance (21, 22) and/or one of the capacitances (61, 62) of the output current filter (6) using the determined respective voltage and the measured currents (Ia, Ib, Ic).

2. The method as claimed in claim 1, in which the voltage across at least one of the intermediate circuit capacitances (21, 22) of the photovoltaic system is measured, the capacitance value of the at least one intermediate circuit capacitance (21, 22) being determined from the level of a ripple in the voltage and the measured currents (Ia, Ib, Ic).

3. The method as claimed in claim 1, in which the voltage across at least one first capacitance (61) of the output current filter (6) is determined, the capacitance value of the at least one first capacitance (61) being determined from the determined voltage and the measured currents (Ia, Ib, Ic).

4. The method as claimed in one of claims 1 to 3, in which AC voltage is applied in phase to all outputs of the inverter bridge (3) of the inverter (9).

5. The method as claimed in claim 1, in which the voltage across at least one second capacitance (62) of the output current filter (6) is determined, the capacitance value of the at least one second capacitance (62) being determined using at least two measurements of voltages and currents (Ia, Ib, Ic), the at least two measurements being carried out with different phase relationships of the AC voltages at the outputs of the inverter bridge (3).

6. The method as claimed in claim 5 carried out in a three-phase inverter (9), an in-phase AC voltage respectively being applied to two outputs of the inverter bridge (3) in each of the at least two measurements and an AC voltage which differs therefrom in terms of its phase angle being applied to a third output of the inverter bridge (3).

7. The method as claimed in claim 6, in which the AC voltage applied to the third output has a phase angle of 180 degrees with respect to the AC voltage applied to the other two outputs of the inverter bridge (3).

8. The method as claimed in claim 5 or 6, in which three measurements are carried out, the AC voltage which differs in terms of its phase angle being applied to a different one of the outputs of the inverter bridge (3) in each of the measurements.

9. The method as claimed in one of claims 1 to 8, in which a determined capacitance value (C) is compared with a predefined minimum capacitance value (Cmin), a capacitance value (C) below the minimum capacitance value (Cmin) being signaled.

10. The method as claimed in one of claims 1 to 9, in which a determined capacitance value (C) is stored and is compared with previously stored capacitance values.

11. The method as claimed in claim 10, in which a rate of change of the capacitance value is determined from the determined capacitance value (C) and at least one stored capacitance value, a service life of the capacitor providing the capacitance being estimated using the rate of change.

12. The method as claimed in one of claims 1 to 11, which is carried out repeatedly during a starting process of the inverter (9).

13. The method as claimed in claim 12, the method being carried out for the purpose of heating capacitors in the intermediate circuit (2) if the determined intermediate circuit capacitance (21, 22) changes.

14. The method as claimed in one of claims 1 to 13, which is carried out for different frequencies of the AC voltage at the outputs of the inverter bridge (3) in order to determine an inductance value of at least one inductance (63) of the output current filter (6).

15. A multiphase inverter (9) for connection to an energy supply network (8), comprising a control device (5) with an evaluation unit (51), **characterized in that** the control device (5), in conjunction with the evaluation unit (51), is set up to carry out a method as claimed in one of the preceding claims.

## Revendications

1. Procédé de détermination de valeurs de capacités (21, 22, 61, 62) d'une installation photovoltaïque qui comprend un onduleur polyphasé (9) équipé d'un filtre de courant de sortie (6) côté courant alternatif et relié par le biais d'un organe de coupure (7) à un réseau d'alimentation en énergie polyphasé (8) et qui est associé côté courant continu à au moins une capacité de circuit intermédiaire (21, 22), comprenant les étapes consistant à :
- séparer l'installation photovoltaïque du réseau d'alimentation en énergie (8) en ouvrant l'organe de coupure (7) ;
- faire fonctionner l'onduleur (9) pour créer une structure de réseau en îlot, dans lequel une tension alternative en phase est appliquée à au moins deux sorties d'un pont d'onduleur (3) de l'onduleur (9) et un flux de courant est généré entre l'au moins une capacité de circuit intermédiaire (21, 22) et le filtre de courant de sortie (6) ;
- mesurer des courants (Ia, Ib, Ic) passant au niveau des sorties du pont d'onduleur (3) et au moins une tension aux bornes d'une capacité de circuit intermédiaire (21, 22) et/ou d'une capacité (61, 62) du filtre de courant de sortie (6) ; et
- déterminer une valeur de la capacité de circuit intermédiaire (21, 22) et/ou l'une des capacités (61, 62) du filtre de courant de sortie (6) sur la base de la tension respectivement déterminée et des courants mesurés (Ia, Ib, Ic).

2. Procédé selon la revendication 1, dans lequel la tension aux bornes d'au moins l'une des capacités de circuit intermédiaire (21, 22) de l'installation photovoltaïque est mesurée, dans lequel l'au moins une capacité de circuit intermédiaire (21, 22) est déterminée à partir de la hauteur d'une ondulation de la tension et des courants (Ia, Ib, Ic) mesurés.

3. Procédé selon la revendication 1, dans lequel la tension aux bornes d'au moins une première capacité (61) du filtre de courant de sortie (6) est déterminée, dans lequel la valeur de capacité de l'au moins une première capacité (61) est déterminée à partir de la tension déterminée et des courants mesurés (Ia, Ib, Ic).

4. Procédé selon l'une quelconque des revendications 1 à 3, dans lequel une tension alternative est appliquée en phase à toutes les sorties du pont d'onduleur (3) de l'onduleur (9).

5. Procédé selon la revendication 1, dans lequel la tension aux bornes d'au moins une deuxième capacité (62) du filtre de courant de sortie (6) est déterminée, dans lequel la valeur de capacité de l'au moins une deuxième capacité (62) est déterminée sur la base d'au moins deux mesures de tensions et de courants (Ia, Ib, Ic), dans lequel les au moins deux mesures sont effectuées pour des rapports de phase différents des tensions alternatives sur les sorties du pont d'onduleur (3).

6. Procédé selon la revendication 5, mis en oeuvre dans le cas d'un onduleur (9) triphasé, dans lequel, lors de chacune des au moins deux mesures, une tension alternative en phase est appliquée à deux sorties du pont d'onduleur (3) et une tension alternative déphasée par rapport à celle-ci est appliquée à une troisième sortie du pont d'onduleur (3).

7. Procédé selon la revendication 6, dans lequel la tension alternative appliquée à la troisième sortie présente une position de phase de 180 degrés par rapport à la tension alternative appliquée aux deux autres sorties du pont d'onduleur (3).

8. Procédé selon la revendication 5 ou 6, dans lequel trois mesures sont effectuées, dans lequel, lors de chacune des mesures, la tension alternative déphasée est appliquée à une autre des sorties du pont d'onduleur (3).

9. Procédé selon l'une quelconque des revendications 1 à 8, dans lequel une valeur de capacité (C) déterminée est comparée à une valeur de capacité minimale (Cmin) prédéterminée, dans lequel une valeur de capacité (C) se situant en dessous de la valeur de capacité minimale (Cmin) est signalée.

10. Procédé selon l'une quelconque des revendications 1 à 9, dans lequel une valeur de capacité (C) déterminée est stockée et comparée à des valeurs de capacités préalablement stockées.

11. Procédé selon la revendication 10, dans lequel une vitesse de variation de la valeur de capacité est déterminée à partir de la valeur de capacité (C) déterminée et d'au moins une valeur de capacité stockée, dans lequel une durée de vie du condensateur fournissant ladite capacité est estimée sur la base de la vitesse de variation.

12. Procédé selon l'une quelconque des revendications 1 à 11, qui est mis en oeuvre plusieurs fois pendant un processus de démarrage de l'onduleur (9).

13. Procédé selon la revendication 12, dans lequel, lors d'une variation de la capacité de circuit intermédiaire (21, 22) déterminée, le procédé est mis en oeuvre pour chauffer des condensateurs présents dans le circuit intermédiaire (2).

14. Procédé selon l'une quelconque des revendications 1 à 13, qui est mis en oeuvre à différentes fréquences de la tension alternative sur les sorties du pont d'onduleur (3) pour déterminer une valeur d'inductance d'au moins une inductance (63) du filtre de courant de sortie (6).

15. Onduleur polyphasé (9) destiné à être relié à un réseau d'alimentation en énergie (8), comportant un dispositif de commande (5) muni d'une unité d'évaluation (51), **caractérisé en ce que** le dispositif de commande (5), en association avec l'unité d'évaluation (51), est conçu pour mettre en oeuvre un procédé selon l'une quelconque des revendications précédentes.
